# DEMANDE DE BREVET EUROPEEN

(11) **EP 4 391 143 A1**
(43) Date de publication de la demande: **26.06.2024**
(21) Numéro de dépôt: 23218279.0
(22) Date de dépôt: 19.12.2023
(51) Int. Cl.: H01M 10/42, G01R 31/36, H01M 10/44, H01M 10/48, H01M 10/54, G01R 31/387, G01R 31/388, G01R 31/389, G01R 31/378, G01R 31/385

(54) **PROCÉDÉ DE DÉTERMINATION DU TYPE DE CHIMIE D'UNE BATTERIE ÉLECTRIQUE RECHARGEABLE**

(30) Priorité: 21.12.2022 FR 2214100
(71) Demandeur: Commissariat à l'énergie atomique et aux énergies alternatives, 75015 Paris (FR)
(72) Inventeur: KIRCHEV, Angel Zhivkov, 38054 GRENOBLE cedex 09 (FR); LONARDONI, Loïc, 38054 GRENOBLE cedex 09 (FR); MONTARU, Maxime, 38054 GRENOBLE cedex 09 (FR)
(74) Mandataire: INNOV-GROUP

(57) **Abrégé**

L'invention concerne un procédé de détermination du type électrochimique d'une cellule Li-ion, comprenant des étapes consistant à :
- mesurer la tension aux bornes, et si celle-ci est comprise entre deux valeurs prédéterminées, alors :
- mesurer la masse de la cellule,
- injecter un courant normalisé par rapport à la masse, entre une valeur basse et une valeur haute de tension,
- déterminer la valeur de l'acceptance de charge entre lesdites valeur basse et valeur haute,
- comparer la valeur de l'acceptance de charge déterminée à une valeur prédéterminée, et

o si celle-ci est supérieure à la valeur prédéterminée, alors déclarer la cellule comme étant d'un groupe de type NMC ou NCA, apte à une réutilisation,
o si celle-ci est inférieure à la valeur prédéterminée, alors déclarer la cellule comme étant d'un groupe de type LFP, apte à être réutilisée.

## Description

La présente invention concerne le domaine des batteries électriques rechargeables, en particulier Li-ion.

Les batteries électriques Li-ion sont rechargeables. Elles emploient différents matériaux constitutifs pour leur anode et leur cathode. En fonction du choix de ces matériaux, les batteries présentent des tensions d'usage différentes.

On distingue actuellement les 3 familles suivantes de technologies Li-ion.
1. Les batteries à tension haute, ou haute densité d'énergie, qui comprennent des anodes à base de graphite, et des cathodes à base de Cobalt, notamment à base d'oxyde de Nickel-Cobalt-Manganese ou NMC, ou à base d'oxyde de Nickel-Cobalt-Aluminium, ou NCA, ou encore LMO pour Lithium Manganèse Oxide par anglicisme ou LiMnO2.
   Ces batteries présentent une tension d'utilisation généralement comprise entre 2.5V et 4.2V, avec une tension nominale généralement comprise entre 3.6 V et 3.7V ;
2. Les batteries à tension moyenne, ou moyenne densité d'énergie, qui comprennent des anodes à base de graphite, et des cathodes à base de LiFePO₄, ou LFP.
   Ces batteries présentent une tension d'utilisation généralement comprise entre 2.0V et 3.6V, avec une tension nominale généralement comprise entre 3.2 V et 3.3V ;
3. Les batteries à tension basse, ou basse densité d'énergie, qui comprennent des anodes à base de titane, ou LTO, et des cathodes LFP, NCA ou NMC.
   Ces batteries présentent une tension d'utilisation généralement comprise entre 1.5V et 2.7V, avec une tension nominale généralement comprise entre 1.9V (avec une cathode LFP) et 2.3V (avec une cathode NCA).

Dans toute la suite de la demande, on s'intéresse plus particulièrement à distinguer entre les chimies de batteries à tension haute et tension moyenne. A ce titre, les appellations de batteries NMC / NCA / LMO / LFP de la description seront relatives à des batteries avec anode à base de graphite ou carbone, et non à base titane.

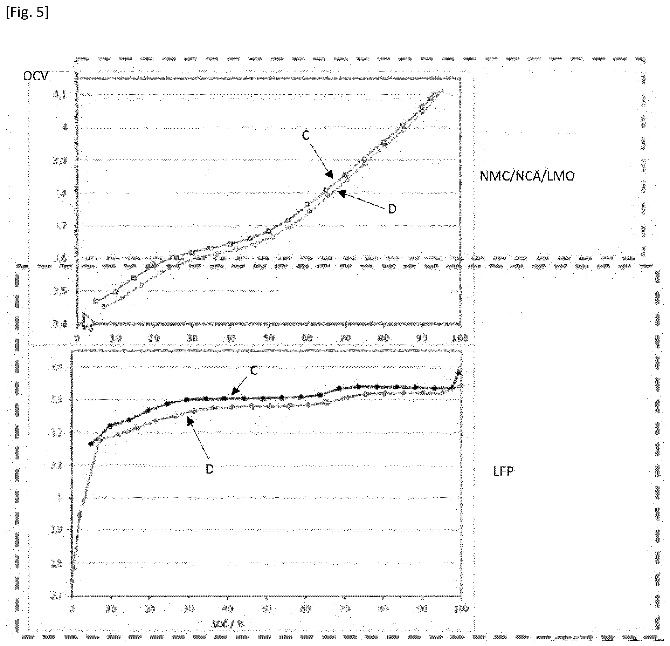

La correspondance entre la tension OCV (en V) aux bornes d'une batterie Li-ion et son état de charge SOC est illustrée sur la figure 5 en charge (courbe C) et en décharge (courbe D).

Il est clair sur la figure 5 que la seule mesure de tension OCV aux bornes d'une batterie Li-ion ne permet pas de distinguer une cellule de type NMC / NCA / LMO d'une cellule de type LFP en particulier dans la zone inférieure à environ 3.6 V.

Par simplification, on entend indistinctement les termes « technologie », « chimie » et « électrochimie » d'une batterie.

Par concision, on entend indistinctement « batterie » et « cellule ». De même, on utilise indistinctement le signe « . » et le signe « , » pour les valeurs décimales.

Certaines des batteries Li-ion ci-dessus présentent un aspect semblable : forme similaire voire identique, volume similaire voire identique.

Ainsi, typiquement lorsqu'elles sont usagées ou en fin de vie, il peut être très difficile de distinguer les différentes batteries, notamment à tension haute / à tension moyenne, particulièrement pour les batteries LFP et NMC/NCA/LMO ; en particulier en l'absence d'étiquette sur celles-ci, ce qui peut arriver avec des batteries usagées, et qui peut de fait poser des problèmes de recyclage ou de réutilisation.

En outre, la seule mesure de la tension aux bornes d'une batterie peut être insuffisante pour déterminer la chimie de celle-ci, en particulier si la batterie est déchargée, c'est-à-dire présente un faible état de charge, SOC par anglicisme de *State Of Charge.*

Typiquement, si une batterie présente une tension supérieure ou égale à 3.6V, il est très probable que la chimie de celle-ci est du NMC, NCA ou LMO. En revanche, quand une batterie présente une tension inférieure à 3.6V, il est possible que la chimie de celle-ci soit du LFP, NMC, NCA, LMO...

Des mesures de spectres d'impédance réelle et imaginaire pour différents états de charge ne permettent pas non plus de discriminer les technologies.

Dans ce contexte, la présente invention concerne selon un premier de ses objets un procédé de détermination du type électrochimique d'une cellule de batterie Li-ion dont le type électrochimique est inconnu, en vue d'attribuer un groupe prédéterminé à la cellule, chaque groupe correspondant à un type électrochimique de cellules donné et une destination possible des cellules dudit groupe en vue de leur recyclage ou de leur réutilisation, le procédé comprenant une étape consistant à :
- mesurer la valeur de la tension aux bornes de la cellule.

Il est essentiellement caractérisé en ce que :
o si la valeur de la tension de la tension mesurée est comprise entre une première valeur prédéterminée et une deuxième valeur prédéterminée,
o alors le procédé comprend en outre des étapes consistant à :
   - injecter dans la cellule un courant prédéterminé, entre une valeur basse prédéterminée de tension et une valeur haute prédéterminée de tension,
   - déterminer la valeur de l'acceptance de charge de la cellule entre la valeur basse prédéterminée de tension et la valeur haute prédéterminée de tension,
   - comparer la valeur de l'acceptance de charge déterminée à une valeur d'acceptance de charge prédéterminée et,
o si la valeur de l'acceptance de charge déterminée est supérieure à la valeur d'acceptance de charge prédéterminée, alors déclarer la cellule comme étant d'un quatrième groupe prédéterminé (G4), de type NMC, NCA ou LMO , apte à une réutilisation,
o si la valeur de l'acceptance de charge déterminée est inférieure à la valeur d'acceptance de charge prédéterminée, alors déclarer la cellule comme étant d'un cinquième groupe prédéterminé (G5), de type LFP, apte à être réutilisée.

On peut prévoir en outre une étape consistant à :
- mesurer la masse ou le volume de la cellule, et
- normaliser le courant injecté dans la cellule par rapport à la masse ou le volume de la cellule.

On peut prévoir en outre des étapes consistant à :
- déterminer la valeur de l'inverse de la résistance interne (Rᵢₙₜ⁻¹) de la cellule, et si la valeur de l'inverse de la résistance interne de la cellule (Rᵢₙₜ⁻¹) est inférieure à une valeur seuil (R_{int_ref}⁻¹) prédéterminée, alors
- déclarer la cellule comme étant d'un deuxième groupe prédéterminé (G2), de type Li-ion dégradée, apte à être recyclée.

On peut prévoir que si la valeur de la tension de la tension mesurée est inférieure à la première valeur prédéterminée, le procédé comprend alors une étape consistant à déclarer la cellule comme étant d'un premier groupe prédéterminé (G1), de type Li-ion dégradée, apte à être recyclé, ou de type basse tension.

On peut prévoir que si la valeur de la tension de la tension mesurée est supérieure à la deuxième valeur prédéterminée, le procédé comprend alors une étape consistant à déclarer la cellule comme étant de type NMC, NCA ou LMO.

On peut prévoir une étape consistant à :
- déterminer la valeur de l'inverse de la résistance interne (Rᵢₙₜ⁻¹) de la cellule, et
   o si la valeur de l'inverse de la résistance interne de la cellule (Rᵢₙₜ⁻¹) est inférieure à une valeur seuil (R_{int_ref}⁻¹) prédéterminée, alors déclarer la cellule comme étant d'un troisième groupe prédéterminé (G3), de type NMC,NCA ou LMO dégradé, et apte à être recyclée,
   o si la valeur de l'inverse de la résistance interne de la cellule (Rint-1) est supérieure à la valeur seuil (R_{int_ref}⁻¹) prédéterminée, alors déclarer la cellule comme étant d'un quatrième groupe prédéterminé (G4), de type NMC, NCA ou LMO apte à être réutilisée.

On peut prévoir en outre, préalablement à la détermination de la valeur de l'acceptance de charge, des étapes de reconditionnement de la cellule consistant à :
- décharger la cellule en deçà d'une première valeur seuil prédéterminée ;
- puis recharger la cellule à courant constant jusqu'à atteindre une deuxième valeur seuil prédéterminée ;
- maintenir cette tension en baissant progressivement la valeur du courant injecté ;
- arrêter la charge quand la valeur du courant devient inférieure à une valeur seuil prédéterminée.

On peut prévoir en outre, après le reconditionnement et préalablement à la détermination de la valeur de l'acceptance de charge, une étape de relaxation de tension.

On peut prévoir que l'étape de détermination de la valeur de l'acceptance de charge comprend une étape consistant à :
- mesurer le temps nécessaire pour que la tension aux bornes de la cellule passe de la valeur basse prédéterminée de tension à la valeur haute prédéterminée de tension lors de l'injection d'un courant prédéterminé, éventuellement normalisé par rapport à la masse ou le volume de la cellule.

On peut prévoir que :
- la valeur basse prédéterminée de tension est comprise entre 3.55 V et 3.65 V ;
- la valeur haute prédéterminée de tension est comprise entre 3.65 V et 3.8 V ;
- la première valeur prédéterminée de tension est de 2,3V ; et
- la deuxième valeur prédéterminée de tension est de 3,6 V.

On peut prévoir que le courant injecté dans la cellule normalisé par rapport à la masse de la cellule est égal à 12 mA / g, plus ou moins 10%.

On peut prévoir que la valeur d'acceptance de charge prédéterminée est de 0,2 mAh/g, entre 3,65 V et 3,7 V et à 12 mA/g de courant de charge.

D'autres caractéristiques et avantages de la présente invention apparaîtront plus clairement à la lecture de la description suivante donnée à titre d'exemple illustratif et non limitatif et faite en référence aux figures annexées.

Les figures ne sont pas à l'échelle.

### DESCRIPTIF DES DESSINS

[Fig. 1] illustre une phase de décharge, une phase de stabilisation et une phase de charge à courant constant, appliquée à une batterie de type NMC et une batterie de type LFP,
[Fig. 2] illustre de manière synchrone avec la figure 1, la réponse en tension de la batterie de type NMC et de la batterie de type LFP,
[Fig. 3] illustre le courant appliqué aux bornes d'une cellule pendant une phase de reconditionnement suivie d'une phase d'acceptance de charge selon l'invention,
[Fig. 4] illustre, de manière synchrone avec la figure 3, la tension aux bornes de la cellule pendant la phase de reconditionnement A suivie de la phase d'acceptance de charge B selon l'invention,
[Fig. 5] illustre la correspondance, en charge et en décharge, entre la tension aux bornes d'une cellule et l'état de charge de la cellule, pour des cellules de type NMC / NCA / LMO et de type LFP,
[Fig. 6] illustre un diagramme d'un mode de réalisation du procédé selon l'invention.

### Description détaillée

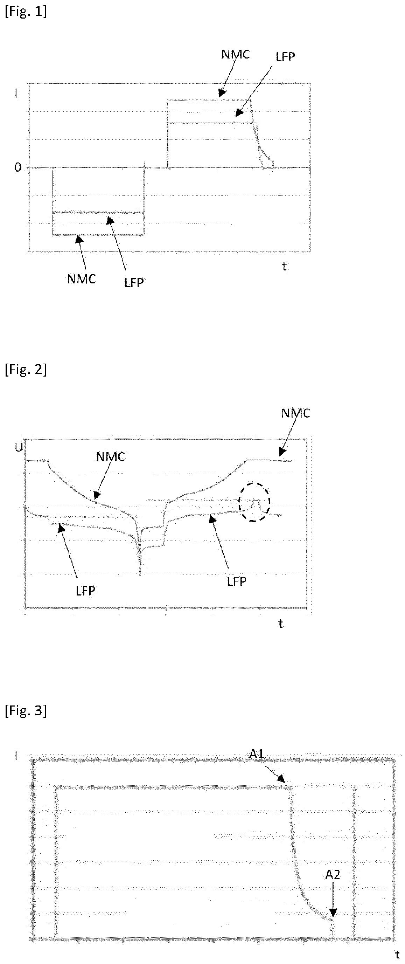

La figure 1 et la figure 2 sont synchrones. Comme illustré sur la figure 1 et la figure 2, qui sont des résultats d'essais menés par la demanderesse, la réponse en tension d'une cellule NMC lors d'une décharge présente un profil similaire au profil d'une cellule LFP lors d'une décharge (intensité I < 0 sur les figures 1 et 2).

Lors de ces essais, après une décharge, on a laissé aux cellules LFP et NMC un temps de repos, de relaxation (intensité I = 0 sur les figures 1 et 2).

Après la phase de relaxation, on a chargé les cellules LFP et NMC à courant constant (intensité I > 0 sur les figures 1 et 2).

Lors de la charge, le profil d'une cellule LFP est comparable au profil d'une cellule NMC jusqu'à l'atteinte du maximum de charge de la cellule LFP, en pointillés sur la figure 2.

La présente invention tire astucieusement avantage de cette caractéristique de réponse en tension pour distinguer, caractériser, les batteries de type LFP de celles de type NMC, NCA, LMO.

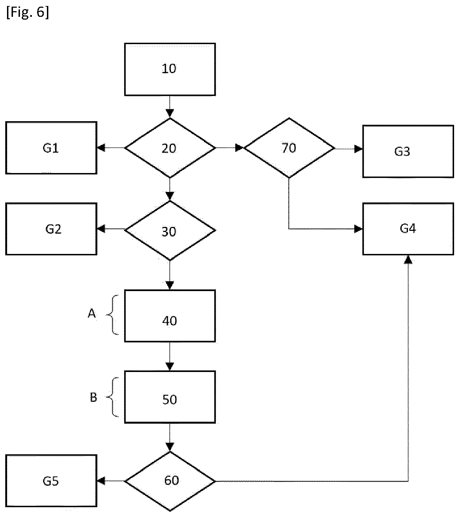

Un synoptique d'un mode de réalisation de l'invention est illustré sur la figure 6.

Il comprend un ensemble d'étapes qui sont détaillées ci-après.

On prévoit tout d'abord une étape **10** de mesures. Elle comprend notamment la mesure de la valeur de la tension aux bornes de la cellule, et la mesure de la masse de la cellule.

On prévoit ensuite une étape **20** de comparaison de la valeur de la tension mesurée à deux valeurs de tension de référence : une première valeur de tension prédéterminée, et une deuxième valeur de tension prédéterminée, différente de la première.

En l'espèce, on prévoit que la première valeur de tension prédéterminée est égale à 2,3 V plus ou moins 10%, et que la deuxième valeur de tension prédéterminée est égale à 3,6 V plus ou moins 10%.
1. Si la valeur de la tension de la tension mesurée est inférieure à la première valeur prédéterminée (2,3 V), le procédé comprend alors une étape consistant à déclarer la cellule comme étant d'un premier groupe prédéterminé G1. En l'espèce, le premier groupe prédéterminé G1 signifie que la cellule est de type Li-ion dégradée ou de type basse tension, apte à être recyclée.
2. Si la valeur de la tension de la tension mesurée est supérieure à la deuxième valeur prédéterminée (3,6 V), le procédé comprend alors une étape consistant à une étape consistant à déclarer la cellule comme étant de type NMC, NCA ou LMO.

Dans ce cas, on prévoit de préférence une étape **70** consistant à déterminer la valeur de la résistance interne de la cellule.

Si la valeur de l'inverse de la résistance interne Rᵢₙₜ⁻¹ de la cellule est inférieure à une valeur seuil R_{int_ref}⁻¹ prédéterminée, alors on peut prévoir de déclarer la cellule comme étant d'un troisième groupe G3 prédéterminé. En l'espèce, le troisième groupe G3 signifie que la cellule est de type NMC, NCA ou LMO dégradé et donc apte à être recyclée.

Si la valeur de l'inverse de la résistance interne Rᵢₙₜ⁻¹ de la cellule est supérieure à la valeur seuil R_{int_ref}⁻¹ prédéterminée, alors on peut prévoir de déclarer la cellule comme étant d'un quatrième groupe G4 prédéterminé. En l'espèce, le quatrième groupe G4 signifie que la cellule est de type NMC, NCA ou LMO apte à être réutilisée.

En l'espèce, on prévoit que la valeur seuil de résistance interne seuil prédéterminée est telle que R_{int_ref}⁻¹ = 0,22 S/g, plus ou moins 10%.
3. Si la valeur de la tension de la tension mesurée est comprise entre une première valeur prédéterminée et une deuxième valeur prédéterminée, alors après l'étape 20 de comparaison de la valeur de la tension, on peut prévoir une étape **30** consistant à déterminer la valeur de la résistance interne de la cellule. L'étape 30 de détermination de la valeur de la résistance interne de la cellule est similaire, et en l'espèce identique, à l'étape 70 de détermination de la valeur de la résistance interne de la cellule. De la sorte l'étape 30 et l'étape 70 peuvent n'être qu'une seule et même étape, mise en oeuvre une seule fois éventuellement en amont ou en parallèle de l'étape 10 de mesures.

En l'espèce, en fonction du résultat de l'étape 30 consistant à déterminer la valeur de la résistance interne de la cellule :
Si la valeur de l'inverse de la résistance interne Rᵢₙₜ⁻¹ de la cellule est inférieure à une valeur seuil R_{int_ref}⁻¹ prédéterminée, alors on peut prévoir de déclarer la cellule comme étant d'un deuxième groupe G2 prédéterminé. En l'espèce, le deuxième groupe G2 signifie que la cellule est de type Li-ion dégradée, apte à être recyclée.

En l'espèce, on prévoit que la valeur seuil de résistance interne seuil prédéterminée est telle que R_{int_ref}⁻¹ = 0,22 S/g, plus ou moins 10%.

Si la valeur de l'inverse de la résistance interne Rᵢₙₜ⁻¹ de la cellule est supérieure à la valeur seuil R_{int_ref}⁻¹ prédéterminée, alors on peut prévoir de poursuivre le procédé selon l'invention par une étape de reconditionnement comme décrit ci-après.

### Reconditionnement

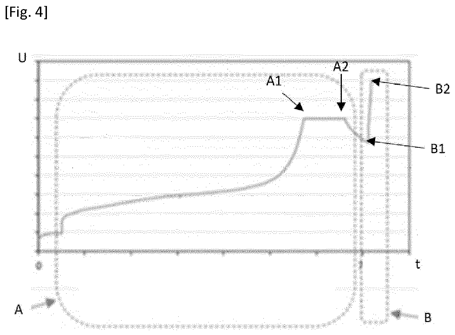

Lorsque la valeur de l'inverse de la résistance interne Rᵢₙₜ⁻¹ de la cellule est supérieure à la valeur seuil R_{int_ref}⁻¹ prédéterminée, on prévoit avantageusement une étape **40** de reconditionnement de la cellule, illustrée par la zone en pointillés référencée A sur la figure 4.

A cet effet, on prévoit tout d'abord de décharger la cellule en deçà d'une première valeur seuil prédéterminée.

L'étape de décharge consiste à décharger la cellule :
- soit totalement,
- soit partiellement, c'est-à-dire en deçà d'une valeur prédéterminée, en l'espèce en deçà de de la valeur basse de tension (2,3 V).

Après la décharge, on prévoit de recharger la cellule à courant constant, comme illustré sur la figure 3, jusqu'à atteindre une valeur seuil prédéterminée de tension, en l'espèce comprise entre 3,6 V et 3,8 V, et de préférence égale à 3,7 V, représenté par le point A1 sur la figure 3 et sur la figure 4.

On prévoit alors de maintenir cette tension en baissant progressivement la valeur du courant injecté, comme illustré entre les points A1 et A2 sur la figure 3.

Cette étape de maintien en tension est illustrée par le plateau de tension U entre les points A1 et A2 sur la figure 4, le plateau correspondant à une tension constante dans le temps. Pour maintenir en tension, on charge la batterie à tension constante, en baissant progressivement la valeur du courant injecté lors de la charge, comme illustré entre les points A1 et A2 sur la figure 3.

Lorsque la valeur du courant devient inférieure à une valeur seuil prédéterminée, on prévoit alors d'arrêter la charge de la cellule, comme illustré par le point A2 sur la figure 3 et la figure 4.

Quand la valeur du courant devient inférieure à la valeur seuil prédéterminée, on considère que la batterie est complètement chargée, et le système de gestion de la batterie (BMS) arrête la charge de celle-ci.

Après l'arrêt de la charge, il existe alors un phénomène de relaxation de tension, comme illustré entre les points A2 et B1 sur la figure 4.

La relaxation de tension est telle que la tension aux bornes de la batterie diminue naturellement pour atteindre une tension de relaxation, sensiblement stable dans le temps.

On peut alors mettre en oeuvre une étape d'acceptance de charge.

### Acceptance de charge

L'acceptance de charge est définie comme la capacité d'une cellule à accepter un courant entre deux valeurs de tension prédéterminées : une valeur basse de tension, en l'espèce la tension de relaxation, et une valeur haute de tension, en l'espèce une valeur cible.

On peut prévoir une étape **50** d'acceptance de charge de la cellule, indistinctement appelée de test d'acceptance de charge, illustrée par la zone en pointillés référencée B sur la figure 4.

A partir de la relaxation de tension, la mesure d'acceptance de charge permet la caractérisation de la chimie de la batterie.

Le temps de relaxation de tension est variable et peut s'étaler de quelques minutes à quelques heures. En l'espèce, on prévoit un temps de relaxation (entre les points A2 et B1 sur la figure 4) supérieur ou égal à 10 minutes. On peut prévoir un temps de relaxation prédéterminé ou un temps de relaxation correspondant à une tension de relaxation prédéterminée, ou encore à une stabilisation de la tension. En l'espèce, on prévoit une tension de relaxation comprise entre 3.55 V et 3.65 V, et plus particulièrement égale à 3.6 V.

Après la relaxation de tension, on injecte dans la batterie un courant prédéterminé, en l'espèce normalisé par rapport au poids de la batterie.

Le courant appliqué est normalisé par rapport à la masse de la cellule (mA / g), ou normalisé par rapport au volume de la cellule (mA / cm³), la relation entre la masse et le volume d'une cellule étant sensiblement linéaire.

De préférence, le courant injecté pour l'acceptance de charge est le même que le courant injecté pour la charge de la batterie. De préférence, on prévoit que le courant injecté normalisé est compris entre 5 mA/g et 15 mA/g, et en l'espèce égal 12 mA/g avec une marge d'erreur de 10%.

On mesure alors le temps nécessaire pour que la tension aux bornes de la batterie atteigne une valeur cible prédéterminée, illustré par le point B2 sur la figure 4.

De préférence, la valeur cible prédéterminée est comprise entre 3,6V et 3,8V, et en l'espèce entre 3.65 V et 3.7 V, de sorte qu'elle n'endommage pas la cellule.

En multipliant la valeur du temps par la valeur du courant, on peut déterminer l'acceptance de charge de la batterie, c'est-à-dire le nombre de Coulomb ou de mAh/g, entre deux valeurs de tension, en l'espèce pour passer de la tension de relaxation à la tension cible.

L'augmentation de la tension aux bornes de la cellule, qui correspond à un nombre de Coulons ou de mAh/g, c'est-à-dire à la valeur de l'acceptance de charge de la batterie, permet de distinguer 2 électrochimies, donc de caractériser celle-ci, c'est-à-dire de déterminer l'électrochimie de la batterie.

A cette fin, on peut mettre en oeuvre une étape 60 consistant à comparer la valeur de l'acceptance de charge déterminée à une valeur d'acceptance de charge prédéterminée, en l'espèce égale à 0,2 mAh/g, plus ou moins 10%.

Si la valeur de l'acceptance de charge déterminée est supérieure à la valeur d'acceptance de charge prédéterminée, alors on prévoit de déclarer la cellule comme étant du quatrième groupe prédéterminé G4, de type NMC, NCA ou LMO, apte à une réutilisation, comme vu précédemment.

Si la valeur de l'acceptance de charge déterminée est inférieure à la valeur d'acceptance de charge prédéterminée, alors on prévoit de déclarer la cellule comme étant d'un cinquième groupe prédéterminé G5, de type LFP, apte à être réutilisée.

Ainsi, la détermination de l'acceptance de charge grâce à un reconditionnement avec un courant normalisé par rapport à la masse de la cellule permet de distinguer le type de cellule lorsque la valeur de la tension aux bornes de la cellule est comprise entre la première valeur de tension prédéterminée (en l'espèce 2,3 V plus ou moins 10%), et que la deuxième valeur de tension prédéterminée (en l'espèce 3,6 V plus ou moins 10%).

## Revendications

1. Procédé de détermination du type électrochimique d'une cellule de batterie Li-ion dont le type électrochimique est inconnu, en vue d'attribuer un groupe prédéterminé à la cellule, chaque groupe correspondant à un type électrochimique de cellules donné et une destination possible des cellules dudit groupe en vue de leur recyclage ou de leur réutilisation, le procédé comprenant une étape consistant à :
- mesurer la valeur de la tension aux bornes de la cellule,
**caractérisé en ce que** :
∘ si la valeur de la tension de la tension mesurée est comprise entre une première valeur prédéterminée et une deuxième valeur prédéterminée,
∘ alors le procédé comprend en outre des étapes consistant à :
- injecter dans la cellule un courant prédéterminé, entre une valeur basse prédéterminée de tension et une valeur haute prédéterminée de tension,
- déterminer la valeur de l'acceptance de charge de la cellule entre la valeur basse prédéterminée de tension et la valeur haute prédéterminée de tension,
- comparer la valeur de l'acceptance de charge déterminée à une valeur d'acceptance de charge prédéterminée et,
∘ si la valeur de l'acceptance de charge déterminée est supérieure à la valeur d'acceptance de charge prédéterminée, alors déclarer la cellule comme étant d'un quatrième groupe prédéterminé (G4), de type NMC, NCA ou LMO , apte à une réutilisation,
∘ si la valeur de l'acceptance de charge déterminée est inférieure à la valeur d'acceptance de charge prédéterminée, alors déclarer la cellule comme étant d'un cinquième groupe prédéterminé (G5), de type LFP, apte à être réutilisée.

2. Procédé selon la revendication 1, comprenant en outre une étape consistant à :
- mesurer la masse ou le volume de la cellule, et
- normaliser le courant injecté dans la cellule par rapport à la masse ou le volume de la cellule.

3. Procédé selon la revendication 1 ou 2, comprenant en outre des étapes consistant à :
- déterminer la valeur de l'inverse de la résistance interne (Rᵢₙₜ⁻¹) de la cellule, et si la valeur de l'inverse de la résistance interne de la cellule (Rᵢₙₜ⁻¹) est inférieure à une valeur seuil (R_{int_ref}⁻¹) prédéterminée, alors
- déclarer la cellule comme étant d'un deuxième groupe prédéterminé (G2), de type Li-ion dégradée, apte à être recyclée.

4. Procédé selon l'une quelconque des revendications précédentes, dans lequel si la valeur de la tension de la tension mesurée est inférieure à la première valeur prédéterminée, le procédé comprend alors une étape consistant à déclarer la cellule comme étant d'un premier groupe prédéterminé (G1), de type Li-ion dégradée, apte à être recyclé, ou de type basse tension.

5. Procédé selon l'une quelconque des revendications précédentes, dans lequel si la valeur de la tension de la tension mesurée est supérieure à la deuxième valeur prédéterminée, le procédé comprend alors une étape consistant à déclarer la cellule comme étant de type NMC, NCA ou LMO.

6. Procédé selon la revendication 5, comprenant en outre une étape consistant à :
- déterminer la valeur de l'inverse de la résistance interne (Rᵢₙₜ⁻¹) de la cellule, et
∘ si la valeur de l'inverse de la résistance interne de la cellule (Rᵢₙₜ⁻¹) est inférieure à une valeur seuil (R_{int_ref}⁻¹) prédéterminée, alors déclarer la cellule comme étant d'un troisième groupe prédéterminé (G3), de type NMC,NCA ou LMO dégradé, et apte à être recyclée,
∘ si la valeur de l'inverse de la résistance interne de la cellule (Rᵢₙₜ⁻¹) est supérieure à la valeur seuil (R_{int_ref}⁻¹) prédéterminée, alors déclarer la cellule comme étant d'un quatrième groupe prédéterminé (G4), de type NMC, NCA ou LMO apte à être réutilisée.

7. Procédé selon l'une quelconque des revendications précédentes, comprenant en outre, préalablement à la détermination de la valeur de l'acceptance de charge, des étapes de reconditionnement de la cellule consistant à :
- décharger la cellule en deçà d'une première valeur seuil prédéterminée ;
- puis recharger la cellule à courant constant jusqu'à atteindre une deuxième valeur seuil prédéterminée ;
- maintenir cette tension en baissant progressivement la valeur du courant injecté ;
- arrêter la charge quand la valeur du courant devient inférieure à une valeur seuil prédéterminée.

8. Procédé selon la revendication 7, comprenant en outre, après le reconditionnement et préalablement à la détermination de la valeur de l'acceptance de charge, une étape de relaxation de tension.

9. Procédé selon l'une quelconque des revendications précédentes, dans lequel l'étape de détermination de la valeur de l'acceptance de charge comprend une étape consistant à :
- mesurer le temps nécessaire pour que la tension aux bornes de la cellule passe de la valeur basse prédéterminée de tension à la valeur haute prédéterminée de tension lors de l'injection d'un courant prédéterminé, éventuellement normalisé par rapport à la masse ou le volume de la cellule.

10. Procédé selon l'une quelconque des revendications précédentes, dans lequel :
- la valeur basse prédéterminée de tension est comprise entre 3.55 V et 3.65 V ;
- la valeur haute prédéterminée de tension est comprise entre 3.65 V et 3.8 V ;
- la première valeur prédéterminée de tension est de 2,3V ; et
- la deuxième valeur prédéterminée de tension est de 3,6 V.

11. Procédé selon l'une quelconque des revendications précédentes, dans lequel le courant injecté dans la cellule normalisé par rapport à la masse de la cellule est égal à 12 mA / g, plus ou moins 10%.

12. Procédé selon l'une quelconque des revendications précédentes, dans lequel la valeur d'acceptance de charge prédéterminée est de 0,2 mAh/g, entre 3,65 V et 3,7 V et à 12 mA/g de courant de charge.
